# EUROPÄISCHE PATENTANMELDUNG

(11) **EP 2 273 276 A1**
(43) Veröffentlichungstag der Anmeldung: **12.01.2011**
(21) Anmeldenummer: 10006902.0
(22) Anmeldetag: 05.07.2010
(51) Int. Cl.: G01R 11/04, H02B 1/03

(54) **Abdeckung für den Anschlussplatz eines Stromzählers**

(30) Priorität: 06.07.2009 DE 102009031989
(71) Anmelder: Hager Electro GmbH & Co. KG, 66440 Blieskastel (DE)
(72) Erfinder: Dr.-Ing. Kelaiditis, Konstantin, 66386 St. Ingbert (DE)
(74) Vertreter: Bernhardt, Reinold

(57) **Zusammenfassung**

Eine Abdeckung für den Anschlussplatz eines Stromzählers, insbesondere elektronischen Haushaltszählers, und ggf. Halterung für den später anzuschließenden Stromzähler, weist eine Grundplatte (2) auf, deren Rückseite im Wesentlichen wie die Rückseite des Stromzählers gestaltet ist mit Haken (7) zum Befestigen an einer Befestigungs- und Kontaktiereinrichtung des Anschlussplatzes und Stiften (8) zum sperrenden Eingreifen zwischen die Kontakte, wobei die Haken (7) und Stifte (8) in einer Montagestellung in die Befestigungs- und Kontaktiereinrichtung zu stecken sind bis zur Anlage der Grundplatte (2) an dem Anschlussplatz und dann die Abdeckung nach unten in die Funktionsstellung zu verschieben ist und in dieser Funktionsstellung gesichert ist durch ein Riegelelement (15), das von der Abdeckung in den Anschlussplatz greift und gegen Entfernen aus der Eingriffstellung, insbesondere durch eine Plombierung (26), gesichert werden kann.

Das Riegelelement (15) ist an einem federnden Arm (12) der Abdeckung ausgebildet derart, dass es sich bei dem Anlegen der Grundplatte (2) an dem Anschlussplatz in der Montagestellung unter Verbiegen des Armes (12) zurückdrücken lässt und beim Verschieben der Abdeckung in die Funktionsstellung in seine Eingriffstellung an dem Anschlussplatz einrastet und sich bei Rückverschieben in die Montagestellung mittels einer schrägen Rutschfläche (16) aus der Eingriffstellung heraushebt.

## Beschreibung

Die Erfindung betrifft eine Abdeckung für den Anschlussplatz eines Stromzählers, insbesondere elektronischen Haushaltszählers, und ggf. Halterung für den später anzuschließenden Stromzähler, die in ihrer Funktionsstellung gesichert ist durch ein Riegelelement, das von der Abdeckung in den Anschlussplatz greift und gegen Entfernen aus der Eingriffstellung, insbesondere durch eine Plombierung, gesichert werden kann.

Eine solche Abdeckung und zugleich Halterung für den Stromzähler ist durch Benutzung bekannt mit einer Grundplatte, deren Rückseite im Wesentlichen wie die Rückseite des Stromzählers gestaltet ist mit Haken zum Befestigen an einer Befestigungs- und Kontaktiereinrichtung des Anschlussplatzes und Stiften zum Eingreifen in die Kontaktiereinrichtung, wobei die Haken und Stifte in einer Montagestellung in die Befestigungs- und Kontaktiereinrichtung zu stecken sind bis zur Anlage der Grundplatte an dem Anschlussplatz und dann die Abdeckung nach unten in die Funktionsstellung zu verschieben ist.
Sie wird in gleicher Weise angebracht wie der Stromzähler, jedoch um den Anschluss zu sperren, und in gleicher Weise gegen Entfernen gesichert, d.h. gegen Rückverschieben, bis die Haken außer Eingriff kommen. Dazu dient ein plombierbarer Stift. Ist ein Zähler auf der Abdeckung "geparkt", so kann er an dieser in gleicher Weise gesichert werden mittels des plombierbaren Stiftes, mit dem der Zähler bei seiner unmittelbaren Anbringung an der Befestigungs- und Kontaktiereinrichtung gesichert wird. Es genügt dann das Plombieren des Stiftes an dem Zähler; der Stift an der Abdeckung und Halterung braucht hier nicht plombiert zu werden, da er wegen des darüber angeordneten Zählers nicht zugänglich ist.

Der Erfindung liegt die Aufgabe zugrunde, die mit dem Sperren des Anschlusses und ggf. dem Parken eines Stromzählers insgesamt verbundenen Handhabungen zu vereinfachen.

Gemäß der Erfindung wird dieser Zweck bei einer Abdeckung der eingangs genannten Art dadurch erfüllt, dass das Riegelelement federnd an der Abdeckung angeordnet ist derart, dass es beim Positionieren der Abdeckung in ihrer Funktionsstellung in eine Eingriffstellung an dem Anschlussplatz einrastet.

Durch die einschließlich des Riegelelementes einstückige Ausbildung der Abdeckung entfallen die gesonderte Herstellung des bisher verwendeten plombierbaren Stiftes, die für den Stift notwendige Logistik und die Handhabungen zum Montieren des Stiftes.

Zweckmäßigerweise ist das Riegelelement an einem federnden Arm der Abdeckung angeordnet.

Zum Lösen der Einrastung kann dann an der Abdeckung und ggf. Halterung eine Eingriffsmöglichkeit für ein Werkzeug, insbesondere einen Schraubendreher, derart eingerichtet sein, dass der federnde Arm mittels des Werkzeugs angehoben werden kann.
Nach einer besonders vorteilhaften Weiterbildung der Erfindung ist jedoch an einer Abdeckung der oben konkreter angegebenen bekannten Konstruktion eine Anordnung des Riegelelements an dem Arm derart vorgesehen, dass sich das Riegelelement bei dem Anlegen der Grundplatte an dem Anschlussplatz in der Montagestellung unter Verbiegen des Armes zurückdrücken lässt und beim Verschieben der Abdeckung in die Funktionsstellung in seiner Eingriffstellung an dem Anschlussplatz einrastet und sich bei Rückverschiebung in die Montagestellung mittels einer schrägen Rutschfläche aus der Eingriffstellung heraushebt.

Die Sicherung des Riegelelements gegen Entfernen aus seiner Eingriffstellung durch die Plombierung ist vorzugsweise dergestalt vorgesehen, dass der, vorzugsweise durch einen Einschnitt in einer bzw. der genannten Grundplatte gebildete, federnde Arm gegen Anheben gesichert werden kann durch einen Plombendraht, für den eine Führung quer über den Arm oder einen Ansatz des Armes unter Gegenhaltern der Abdeckung vorgesehen ist, vorzugsweise mit nur geringfügigen Spalten zwischen dem Arm oder Ansatz und den Gegenhaltern.

An den nur geringfügigen Spalten ist der Plombendraht nur auf Scherung und nicht auf Biegung belastet. Die Plombierung kann stärkerer Kraftausübung widerstehen.

Noch weiter vergrößert werden kann die mechanische Festigkeit der Plombensicherung durch die weitere Ausgestaltung, dass der Arm oder Ansatz an der Stelle des Plombendrahtes zweischenklig ist und drei, vorzugsweise als Konsolen auf der Grundplatte ausgebildete, Gegenhalter vorgesehen sind. Die bei einem Versuch der Rückverschiebung in die Montagestellung an der schrägen Rutschfläche generierte Kraft, die das Riegelelement aus der Eingriffstellung herauszuheben sucht, verteilt sich dann auf vier statt zwei Spaltüberbrückungen durch den Plombendraht.

In weiterer vorteilhafter Ausgestaltung der Erfindung fassen die Gegenhalter den Plombendraht von oben bogenförmig ein und die Bögen sind an ihrer offenen Seite in der axialen Projektion durch den Arm oder Ansatz des Armes geschlossen.
Diese Gestaltung ist, auch herstellungstechnisch, besonders einfach und trotzdem ausreichend.

Um bei entferntem Plombendraht die Abdeckung einfach nur durch Rückverschieben unter Herausheben des Riegelelements aus seiner Eingriffstellung aus dem Eingriff ihrer Haken in der Befestigungs- und Kontaktiereinrichtung lösen zu können, kann die Schräge der genannten Rutschfläche geeignet gewählt werden. Die schräge Rutschfläche ist vorzugsweise an dem Riegelelement vorgesehen. Ihre, technisch an sich ebenfalls mögliche, Anbringung an der Befestigungs- und Kontaktiereinrichtung dürfte normalerweise insofern ausscheiden, als hier ein Gegenlager für den herkömmlichen plombierbaren Stift zur Verfügung gestellt wird.

In dem Fall, dass das Anheben des federnden Armes durch die schräge Rutschfläche einmal nicht gelingt, kann auf die vorzugsweise grundsätzlich als Alternative vorgesehene Eingriffsmöglichkeit für einen Schraubendreher o. dgl. zurückgegriffen werden.

Nach einer weiteren Ausgestaltung der Erfindung kann der federnde Arm ebenfalls gegen Anheben gesichert werden durch ein Steckschloss, für das auf dem federnden Arm eine Aufnahme und an der Abdeckung eine dem Schwenkriegel des Steckschlosses zugewandte Gegenfläche ausgebildet ist oder umgekehrt.
Es besteht dann Wahlmöglichkeit zwischen der Plombierung und dem Steckschloss. Ist die Abdeckung zugleich Halterung für den später anzuschließenden Stromzähler, so kann der federnde Arm ebenfalls gegen Anheben gesichert werden durch den aufgesetzten Stromzähler, wobei die Abdeckung und Halterung die Form eines flachen Kastens aufweist, in dem bei auf die Seitenwände des Kastens aufgesetztem Stromzähler die an der Rückseite des Stromzählers herausragenden Stifte Platz finden, und der Zwischenraum zwischen dem Arm und dem Stromzähler durch einen Aufbau auf dem Arm überbrückt ist, vorzugsweise durch die genannte Aufnahme für das Steckschloss, und der aufgesetzte Stromzähler seinerseits gegen Abnehmen gesichert werden kann.

In weiterer Ausgestaltung der Erfindung kann der aufgesetzte Stromzähler gegen Abnehmen gesichert werden durch ein Steckschloss, für das die Abdeckung und Halterung eine Aufnahme aufweist, die an der einen Schmalseitenwand des Kastens ausschwenkbar angeordnet ist. Das Steckschloss sichert den Stromzähler gegen Rückverschieben aus der der genannten Funktionsstellung entsprechenden Haltestellung, in der seine Haken, die in an den Außenseiten der Längsseitenwände des Kastens ausgebildeten Taschen Platz finden, hinter in den Taschen geformte Widerlager greifen.
Dafür weist die Schmalseitenwand vorzugsweise einen Ausschnitt auf und die Aufnahme hat an der einen Seite des Ausschnitts eine biegsame Verbindung mit der Schmalseitenwand und ist an der anderen Seite von innen gegen das Ende der Schmalseitenwand abstützbar.
Der Stromzähler könnte jedoch auch in herkömmlicher Weise durch einen plombierbaren Stift gesichert werden, für den an der Abdeckung und Halterung ein einem Rückverschieben des Stromzählers entgegengerichtetes Gegenlager oder ein entgegengerichteter Anschlag eingerichtet ist.

In einer Weiterbildung der Erfindung ragen die Haken der Abdeckung in der Richtung, in der die Abdeckung in die Funktionsstellung zu verschieben ist, höchstens so weit vor, dass sie nicht über Widerlager für die Haken des Stromzählers bildende Ränder von gegenüberliegend zu den Haken auf der anderen Seite der Abdeckung angeordneten, zur Aufnahme von Haken des Stromzählers vorgesehenen Taschen vorstehen.
Zur Herstellung der Abdeckung mittels Spritzguss sind zur Erzeugung der Taschen bzw. der Haken an einem Spritzgusswerkzeug keine seitlichen Schieber mehr notwendig. Die Abdeckung kann dann zu ihrer Vorder- bzw. Rückseite hin entformt werden. Entsprechend kann ein kostengünstigeres Werkzeug verwendet werden und darüber hinaus der Spritzvorgang schneller durchgeführt werden. Diese Weiterbildung ist von den Merkmalen nach Anspruch 1 unabhängig und kann vorteilhaft auch bei anderen Abdeckungen Anwendung finden.

In einer anderen Weiterbildung der Erfindung, die auch bei Abdeckungen für Anschlussplätze von Stromzählern angewandt werden kann, die nicht die Merkmale des Anspruchs 1 aufweisen, ist die Abdeckung derart eingerichtet, dass ein darunter in einer Befestigungs- und Kontaktiereinrichtung angeordnetes Sende- und Empfangsteil für die Kommunikation mit einem Zähler wahrgenommen werden kann. Vorzugsweise handelt es sich bei einer solchen Einrichtung um eine in der Nähe des Sende- und Empfangsteils angeordnete Prismenanordnung oder einen Spiegel, die bzw. der vorzugsweise in ein Fenster oder einen Eingriff der Abdeckung einzusetzen ist.
Zweckmäßigerweise ist die Abdeckung zur Kommunikation der Sende- und Empfangseinrichtung vorgesehen und vorzugsweise mit einem Sender versehen.
In einer weiteren Ausgestaltung der Erfindung weist die Abdeckung Mittel zur Weiterleitung und/oder Übertragung der Signale der Sende- und Empfangseinrichtung zu einem auf der Abdeckung angeordneten Stromzähler auf.
Vorteilhaft kann somit von der Ferne aus kontrolliert werden, ob die Abdeckung auf dem Anschlussplatz angeordnet oder entfernt worden ist. Unabhängig von der Anwendung dieser Weiterbildung der Erfindung für die Abdeckplatte kann mittels der letztgenannten Einrichtung auch kontrolliert werden, ob der Stromzähler auf der Abdeckung oder direkt auf dem Zählerplatz angeordnet ist, wenn die Abdeckung Mittel zur Übertragung der Signale der Sende- und Empfangseinrichtung zu einem auf der Abdeckung angeordneten Stromzähler aufweist.

Die Zeichnungen geben Ausführungsbeispiele der Erfindung wieder.
- Fig. 1: zeigt eine Draufsicht auf eine erste Abdeckung für den Anschlussplatz eines elektronischen Haushaltszählers und Halterung für den später anzuschließenden Zähler,
- Fig. 2: zeigt eine vereinfachte Seitenansicht der Abdeckung und Halterung ge- mäß Fig. 1 von rechts,
- Fig. 3: zeigt einen Schnitt nach Linie III-III in Fig. 1
- Fig. 4: zeigt einen Ausschnitt aus Fig. 1 in vergrößertem Maßstab,
- Fig. 5: zeigt einen Ausschnitt aus Fig. 4 in noch einmal vergrößertem Maßstab, je- doch in Rückansicht der Abdeckung und Halterung,
- Fig. 6: zeigt die Draufsicht gemäß Fig. 1 in einer anderen Stellung eines Einzelteils,
- Fig. 7: zeigt eine Draufsicht auf eine zweite Abdeckung für den Anschlussplatz eines elektronischen Haushaltszählers und Halterung für den später anzu- schließenden Zähler,
- Fig. 8: zeigt eine Seitenansicht der Abdeckung und Halterung gemäß Fig. 7 von rechts,
- Fig. 9: zeigt einen Schnitt nach Linie IX-IX in Fig. 7,
- Fig. 10: zeigt einen Ausschnitt aus Fig. 7 in vergrößertem Maßstab,
- Fig. 11: zeigt die in Fig. 10 erscheinenden Teile in einer isometrischen Darstellung,
- Fig. 12: zeigt die Draufsicht gemäß Fig. 7 in einer anderen Stellung eines Einzelteils, und
- Fig. 13: zeigt eine Rückansicht der zweiten Abdeckung.

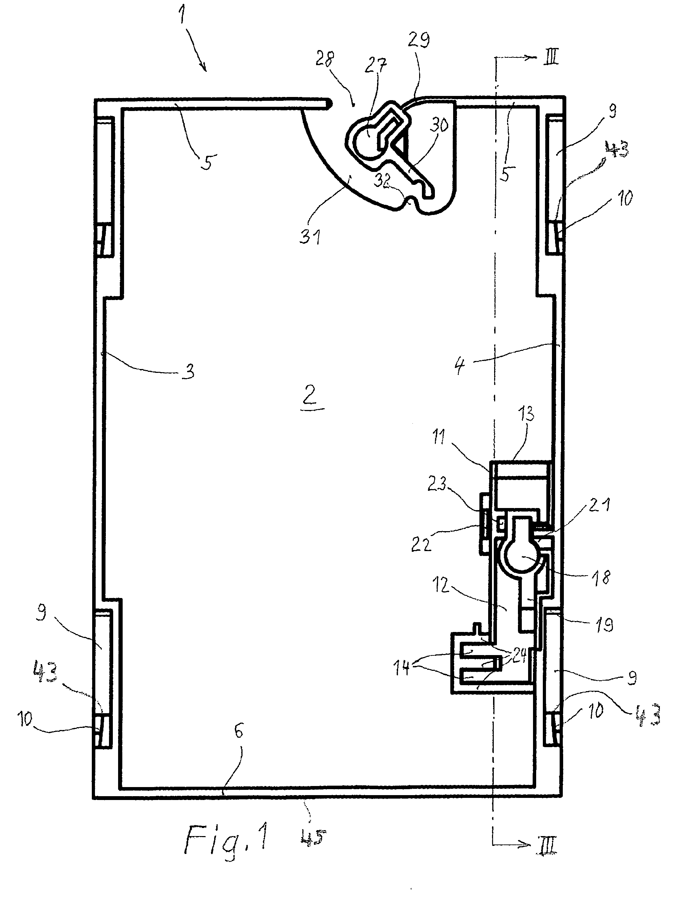

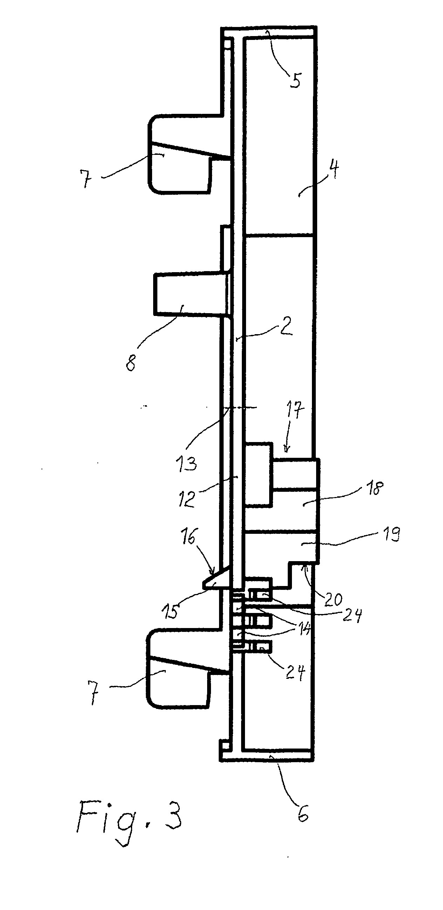

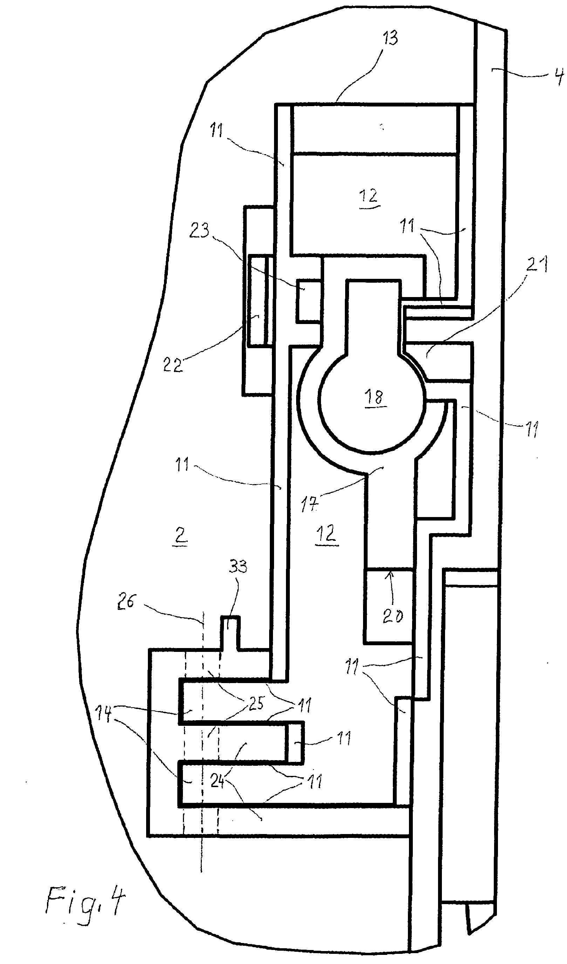

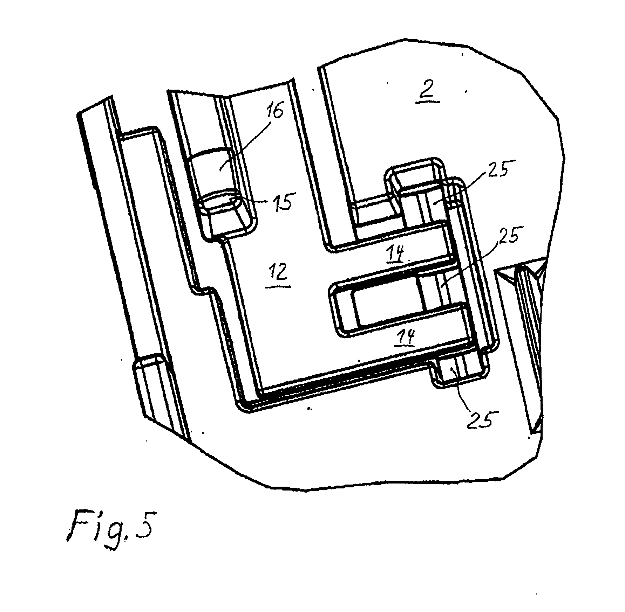

Die Abdeckung und Halterung gemäß Fig. 1 bis 6 hat die Form eines flachen Kastens 1 aus Kunststoff mit einer Grundplatte 2, zwei Längsseitenwänden 3 und 4 und zwei Schmalseitenwänden 5 und 6.

An der Rückseite des Kastens 1 sind nahe den vier Ecken vier Haken 7 und über die Fläche verteilt mehrere Stifte 8 von schmalem, länglichem Querschnitt angeformt.

An den Längsseitenwänden 3 und 4 sind Taschen 9 zur Aufnahme gleicher Haken wie der Haken 7 ausgebildet, jedoch der Haken eines Stromzählers, sowie Widerlager 10, hinter denen die Haken einzuhaken sind.

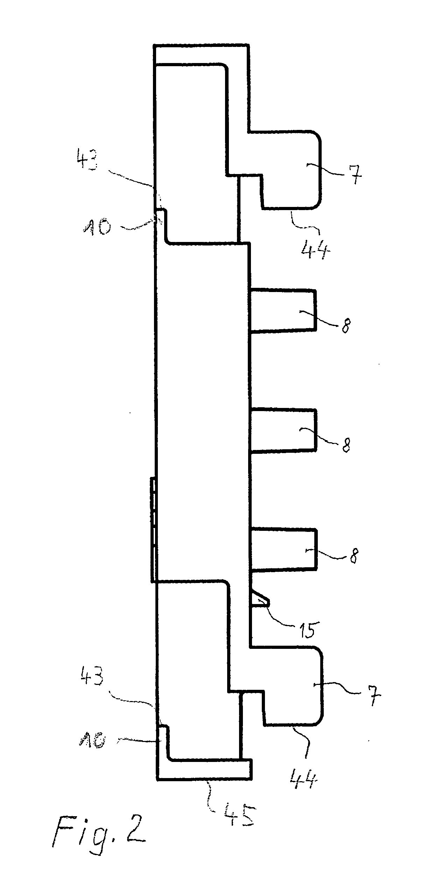

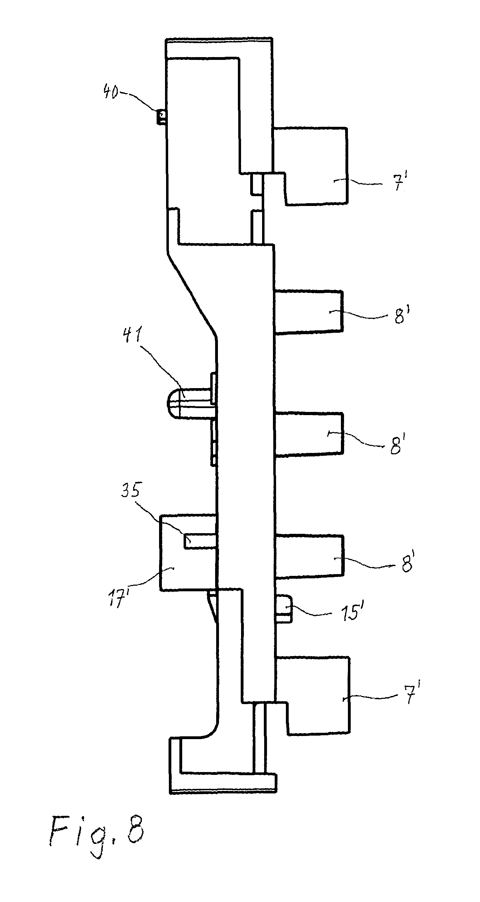

Wie insbesondere aus Fig. 2 und 8 hervorgeht, sind ein den Haken 7 in der Richtung, in der der Stromzähler auf die Abdeckung in eine Parkstellung auf der Abdeckung zu verschieben ist, gegenüberliegender Rand 43 der Taschen 9 und die untere Kante 44 der Haken 7 im selben Abstand zum unteren Rand 45 der Abdeckung angeordnet. Die Haken 7 stehen nur soweit vor, dass sie mit dem Rand 43 auf einer Höhe liegen. Zur Herstellung der Abdeckung mittels Spritzguss sind zur Erzeugung der Taschen 9 bzw. der Haken 7 an einem Spritzgusswerkzeug keine seitlichen Schieber mehr notwendig.

Durch einen entsprechend geführten Einschnitt 11 in der Grundplatte 2 ist ein federnder Arm 12 geschaffen. Er tritt an der Linie 13 aus der Grundplatte 2 heraus und weist an seinem Ende einen zweischenkligen seitlichen Ansatz 14 auf. Insoweit ist der Arm 12 eine blattförmige Fortsetzung der Grundplatte 2.

An der Rückseite tritt aus dem Arm 12 ein Riegelelement 15 heraus. Es hat die Grundform eines Quaders, jedoch mit einer Schrägfläche 16; anders betrachtet ist es in seinen beiden Seitenansichten trapezförmig und in den anderen Ansichten rechteckig.

Auf der Vorderseite weist der Arm 12 einen Aufbau 17 auf. Der Aufbau 17 gliedert sich in eine Aufnahme 18 für ein Steckschloss und einen schmalen Block 19, an dem ein unten noch erklärter Anschlag 20 gebildet ist. In einen seitlichen Ausschnitt der Aufnahme 18 ragt von der Längsseitenwand 4 her - der Einschnitt 11 verläuft auf der einen Seite des Armes 12 entlang der Längsseitenwand 4 - eine schräg ansteigende Gegenfläche 21 für den Riegel des Steckschlosses.

Auf der anderen Seite des Armes 12 ist an der Grundplatte 2 eine Eingriffsteile für einen Schraubendreher mit einer Schrägfläche 22 und dieser gegenüber an dem Arm 12 ein Vorsprung 23 ausgebildet derart, dass hier die Spitze eines Schraubendrehers eingeführt und unter den Vorsprung 23 fassen kann, um den federnden Arm 12 anzuheben.

Während der den Arm 12 von der Grundplatte 2 trennende Einschnitt 11 sonst eine deutlich sichtbare Breite hat, ist er an den beiden Schenkeln des seitlichen Ansatzes 14 auf eine minimale Spaltbreite beschränkt.

Hier erheben sich auf der Grundplatte 2 drei die beiden Schenkel des seitlichen Ansatzes 14 einfassende Konsolen 24, in denen über der Grundplatte 2 jeweils ein bogenförmiger Durchgang 25 für einen strichpunktiert angedeuteten Plombendraht 26 ausgespart ist. Der Plombendraht 26 erstreckt sich somit über die in gleicher Ebene wie die Grundplatte 2 liegenden Schenkel des Ansatzes 14 und hält diese, da er von den Konsolen 24 in den bogenförmigen Durchgängen 25 eingefasst ist, in ihrer Grundstellung fest. Eine Nase 33 dient bei der Montage des Plombendrahtes 26 als Führung.
Damit ist das Riegelelement 15 in seiner Verriegelungsstellung gehalten.

Alternativ kann statt des Plombendrahts 26 ein Steckschloss in die Aufnahme 18 gesetzt und verschlossen werden.

Wie sich aus dem Vorstehenden ergibt, wird die Abdeckung und Halterung ohne Plombendraht oder Steckschloss auf die erwähnte Befestigungs- und Kontaktiereinrichtung gesetzt und mit den Haken 7 und den Stiften 8 in die dort für die entsprechenden Haken und Stifte eines Stromzählers vorhandenen Schlitze gesteckt, wobei das Riegelelement 15 auf der Oberfläche des Befestigungs- und Kontaktiereinrichtung anstößt und der federnde Arm 12 nach vorne biegt. Dann wird die Abdeckung und Halterung aus dieser Montagestellung nach unten verschoben in die Funktionsstellung des Stromzählers, in der sonst der Stromzähler und jetzt die Abdeckung und Halterung fest eingehakt ist.
In dieser Stellung rastet das Riegelelement 15 in einer Ausnehmung der Befestigungs-und Kontaktiereinrichtung ein, die für einen plombierbaren Stift des Stromzählers vorgesehen ist. Werden der Arm 12 und sein Ansatz 14 durch einen Plombendraht 26 oder ein Steckschloss niedergehalten, so kann sich bei dem Versuch einer Rückverschiebung der Abdeckung und Halterung das Riegelelement 15 trotz der schrägen Rutschfläche 16 nicht aus der betreffenden Ausnehmung herausheben. Die Abdeckung und Halterung kann somit nicht ausgehakt und abgenommen werden.

Bei entferntem Plombendraht bzw. entriegeltem Steckschloss wird dagegen durch einfache Rückverschiebung das Riegelelement 15 aus der betreffenden Ausnehmung herausgedrückt; die Abdeckung und Halterung kann in die Montagestellung zurückverschoben werden und von der Befestigungs- und Kontaktiereinrichtung abgehoben werden.

Um den später zu setzenden Stromzähler auf der Abdeckung und Halterung zu "parken", wird er mit seinen Haken in die Taschen 9 gebracht und nach unten verschoben, so dass die Haken unter die Widerlager 10 greifen und der Stromzähler gehalten ist. Gegen Rückverschiebung könnte er durch seinen erwähnten plombierbaren Stift gesichert werden, der dann in Flucht über dem Riegelelement 15 liegt und durch den Anschlag 20 gehalten ist.

Bevorzugt wird jedoch auf den plombierbaren Stift des Stromzählers als gesondertes Teil verzichtet und die an dem Stromzähler alternativ mögliche Sicherung durch ein normales Steckschloss vorgenommen. Dazu dient eine an der Schmalseitenwand 5 des Kastens 1 vorgesehene Aufnahme 27 für das Steckschloss.

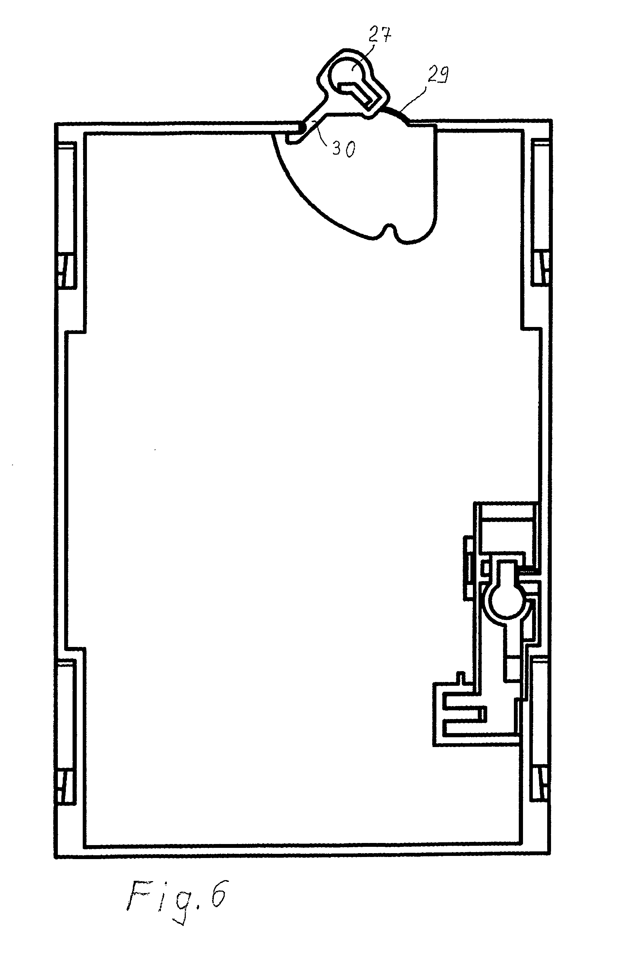

Die Aufnahme 27 ist in einer Unterbrechung 28 der Schmalseitenwand 5 durch einen biegsamen Abschnitt 29 mit dem einen Ende der Schmalseitenwand 5 verbunden und in ihrer in Fig. 6 gezeigten Funktionsstellung mit einem Arm 30 gegen das andere Ende der Schmalseitenwand 5 abgestützt.

In inaktiver Stellung ist die Aufnahme 27 in eine in dem Kasten 1 abgeteilte Kammer 31 eingeschwenkt, wie in Fig. 1 gezeigt. Der Arm 30 kann hier an einem Vorsprung 32 eingehakt werden. Dies soll auch die Spritzstellung der Aufnahme 27 sein.

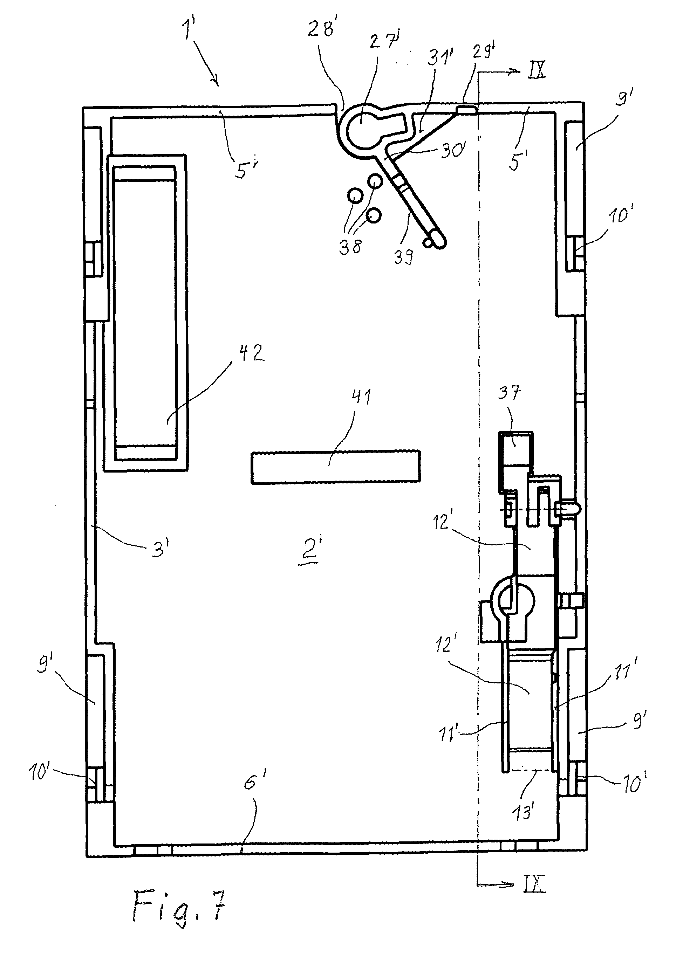

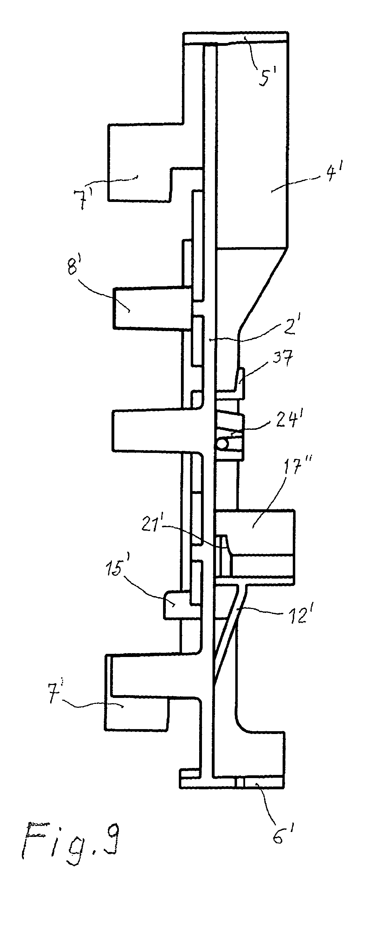

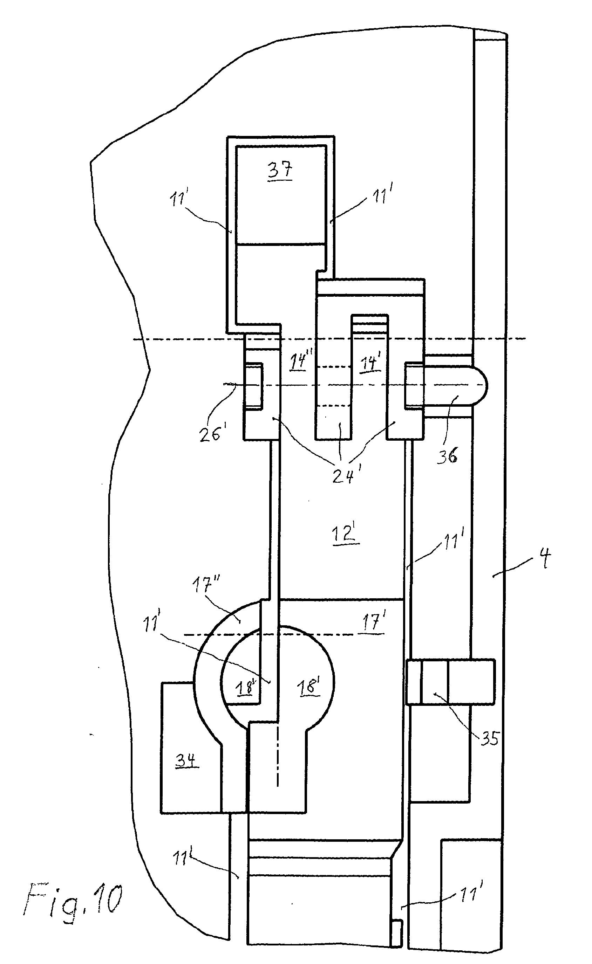

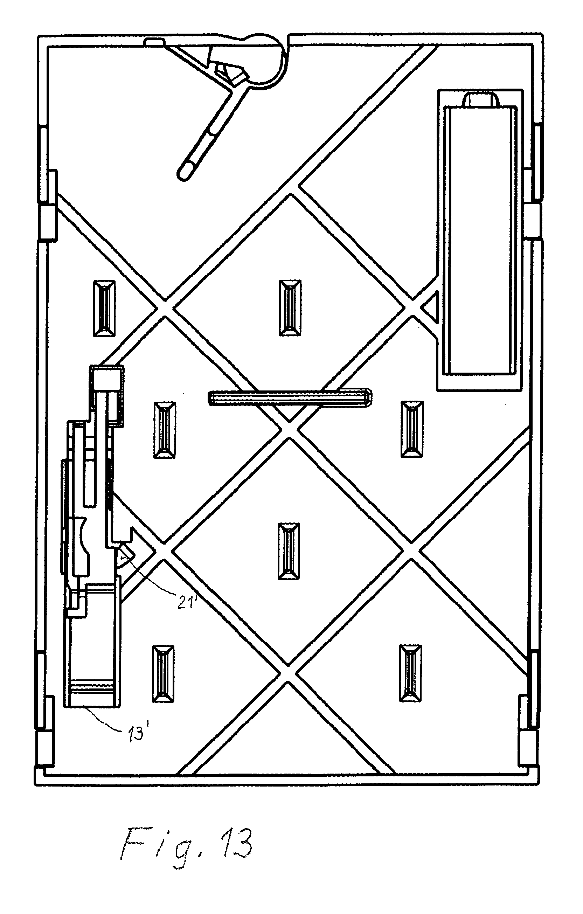

In Fig. 7 bis 13 weisen Fig. 1 bis 6 entsprechende Teile gleiche, jedoch mit' oder " versehene Bezugszeichen auf.

Die Abdeckung und Halterung gemäß Fig. 7 bis 13 hat ebenfalls die Form eines flachen Kastens 1' aus Kunststoff mit einer Grundplatte 2', zwei Längsseitenwänden 3' und 4' und zwei Schmalseitenwänden 5' und 6'. An der Rückseite des Kastens 1' sind nach den vier Ecken vier Haken 7' und über die Fläche verteilt mehrere Stifte 8' von schmalem, länglichen Querschnitt angeformt. An den Längsseitenwänden 3' und 4' sind Taschen 9' zur Aufnahme gleicher Haken wie der Haken 7' ausgebildet, jedoch der Haken eines Stromzählers, sowie Widerlager 10' hinter denen die Haken einzuhaken sind. Auf der Vorderseite ist die Abdeckung mit einem Griff 41 versehen.

In einem entsprechend geformten Ausschnitt 11' der Grundplatte 2' ist ein gegenüber dem Arm 12 abgewandelter federnder Arm 12' angeordnet. Er tritt an der Linie 13' aus der Grundplatte 2' heraus und hat an seinem Ende eine zweischenklige Ausbildung. Der eine Schenkel ist mit 14', der andere mit 14" bezeichnet.

An der Rückseite ragt aus dem Arm 12' ein Riegelelement 15' heraus. Es hat die Form eines Quaders, jedoch mit einer Abrundung 16' an einer Kante.

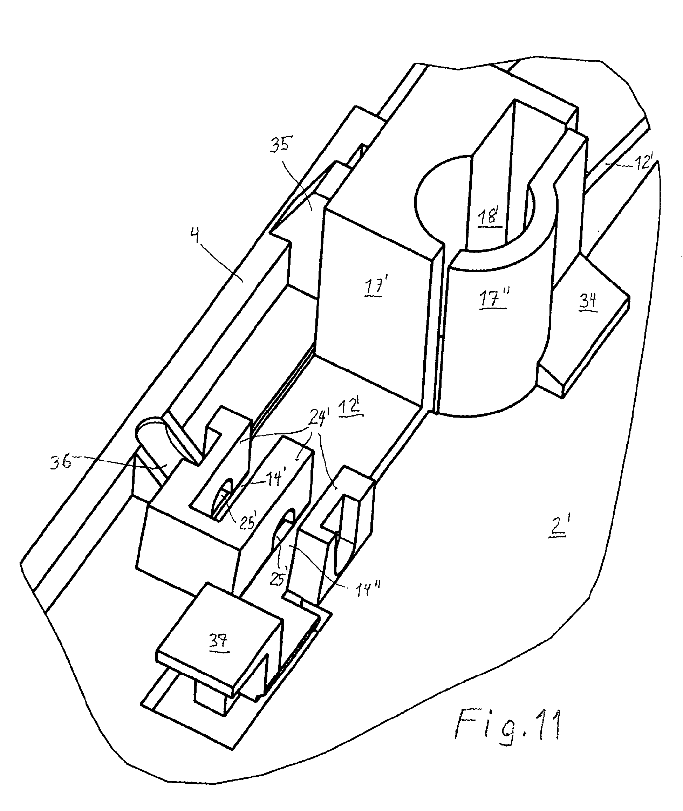

Auf der Vorderseite weist der Arm 12' einen Aufbau 17' auf. Der Aufbau 17' enthält zusammen mit einem ihn ergänzenden Aufbau 17" auf der Grundplatte 2' eine Aufnahme 18' für ein Steckschloss. In dem Aufbau 17" ist eine schräg ansteigende Gegenfläche 21' für den Riegel des Steckschlosses ausgebildet. Sie befindet sich teilweise unter dem in Fig. 11 sichtbaren, schrägen Ansatz 34.
Von der Längsseitenwand 4' her - der Ausschnitt 1 1 ' verläuft auf der einen Seite des Armes 12' entlang der Längsseitenwand 4' - erstreckt sich eine Strebe 35 an den Aufbau 17', jedoch ohne ihn zu berühren. Sie verhindert, dass der Aufbau 17' gegebenenfalls zur Seite weggedrückt werden kann.

Zwischen den beiden Schenkeln 14', 14" und der Grundplatte 2' besteht nur ein Spalt von minimaler Breite. Hier erheben sich auf der Grundplatte 2' drei die beiden Schenkel 14', 14" einfassende Konsolen 24', in denen über der Grundplatte 2' jeweils ein bogenförmiger Durchgang 25' für einen strichpunktiert angedeuteten Plombendraht 26' ausgespart ist. Der Plombendraht 26' erstreckt sich somit über die in gleicher Ebene wie die Grundplatte 2' liegenden Schenkel 14', 14" und hält diese, da er von den Konsolen 24' in den bogenförmigen Durchgängen 25' eingefasst ist, in ihrer Grundstellung fest. Eine ausgekehlte Schrägfläche 36 dient bei der Montage des Plombendrahtes 26' als Führung.
Damit ist das Riegelelement 15' in seiner Verriegelungsstellung gehalten.

Alternativ kann statt des Plombendrahts 26' ein Steckschloss in die Aufnahme 18' gesetzt und verschlossen werden.

Auch diese Abdeckung und Halterung wird ohne Plombendraht oder Steckschloss auf die erwähnte Befestigungs- und Kontaktiereinrichtung gesetzt und mit den Haken 7' und den Stiften 8' in die dort für die entsprechenden Haken und Stifte eines Stromzählers vorhandenen Schlitze gesteckt, wobei das Riegelelement 15' auf der Oberfläche der Befestigungs- und Kontaktiereinrichtung anstößt und der federnde Arm 12' sich nach vorne biegt, und dann aus dieser Montagestellung nach unten verschoben, bis die Abdeckung und Halterung fest eingehakt ist und das Riegelelement 15' in der erwähnten Ausnehmung der Befestigungs- und Kontaktiereinrichtung einrastet. Wird der Arm 12' durch einen Plombendraht 26' oder ein Steckschloss gesichert, so kann das Riegelelement 15' nicht aus der betreffenden Ausnehmung herausgehoben werden. Die Abdeckung und Halterung lässt sich somit nicht aushaken und abnehmen.
Bei entferntem Plombendraht bzw. entriegeltem Steckschloss kann dagegen mittels eines in der Verlängerung des Schenkels 14" ausgebildeten Griffs 37, unter den eine Fingerkuppe fassen kann, der Arm 12' angehoben und das Riegelelement 15' aus der betreffenden Ausnehmung herausgehoben werden.

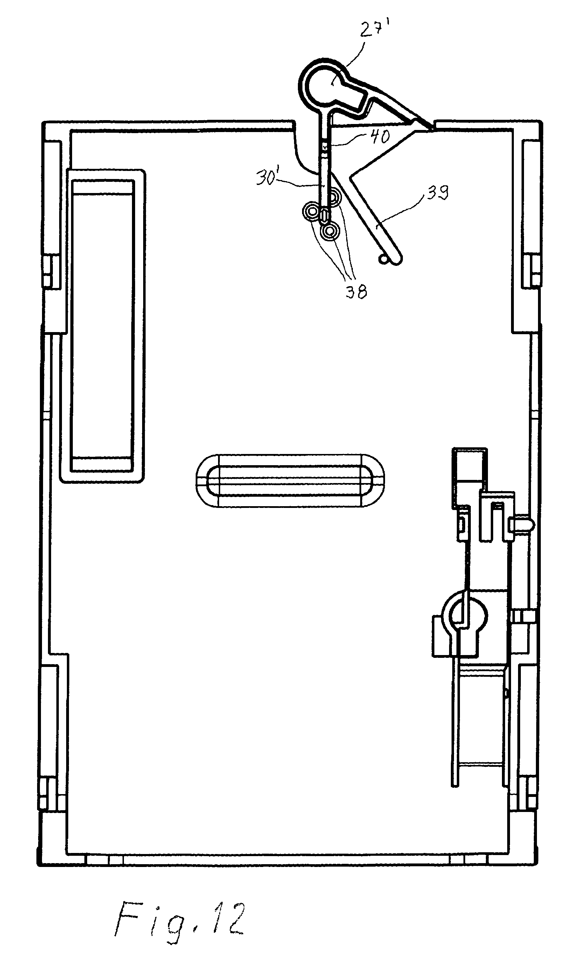

Eine Aufnahme 27' für ein Steckschloss ist in einer Unterbrechung 28' der Schmalseitenwand 5' durch einen biegsamen Abschnitt 29' mit dem einen Ende der Schmalseitenwand 5' verbunden und in ihrer in Fig. 12 gezeigten Funktionsstellung mit einem Arm 30' abgestützt. Zur Abstützung dienen jedoch drei auf der Grundplatte 2' angeordnete Stifte 38.
In inaktiver Stellung ist der Arm 30' der in eine dem Kasten 1' abgeteilte Kammer 31' eingeschwenkten Aufnahme 27', wie in Fig. 7, gezeigt, in einen Schlitz 39 leicht klemmend eingeschoben. Dies ist wiederum die Spritzstellung der Aufnahme. Ein Nocken 40 des Armes 30' ragt nach oben über die Höhe des Kastens 1' hinaus und kann in den ggf. darauf sitzenden Zähler greifen. Damit ist die Aufnahme 27' gegen Herausziehen gesichert.

Ferner ist ein Fenster oder Sitz 42 vorgesehen, das bzw. der von einem darunter in der Befestigungs- und Kontaktiereinrichtung angeordneten Sende- und Empfangsteil für die Kommunikation mit einem Zähler wahrgenommen werden kann.
Dort kann ein Spiegel oder eine Prismenanordnung angeordnet werden derart, dass ein Sendesignal des Sendeteils an das Empfangsteil gespiegelt bzw. geleitet wird. Wird das zurückgespiegelte bzw. geleitete Signal empfangen, bedeutet dies, dass die Abdeckung auf dem Anschlusspiatz sitzt. Alternativ kann auch die Abdeckung mit einem eigenen Sendeteil versehen werden, das in regelmäßigen Abständen Signale an das Empfangsteil des Anschlussplatzes sendet. Das Signal kann Informationen über eine Identität der Abdeckung beinhalten. Voraussetzung dafür ist allerdings, dass das Sendeteil mit Strom versorgt ist. Dies kann über die Stifte 8,8' erfolgen, die dazu aus einem elektrisch leitenden Material zu bilden sind und in einer elektrischen Verbindung mit dem Anschlussplatz stehen. So kann an eine zentrale Kontrolleinrichtung übermittelt werden, ob die Abdeckung auf dem Anschlussplatz bzw. der Stromzähler auf der Abdeckung angeordnet ist oder, möglicherweise durch unbefugten Zugriff, entfernt worden ist. Wird ein die Identität der Abdeckung beinhaltendes Signal gesendet, kann darüber hinaus festgestellt werden, ob eine ursprünglich eingesetzte Abdeckung durch eine andere ersetzt worden ist.

Alternativ kann die mit dem Bezugszeichen 42 gekennzeichnete Stelle auch dazu dienen, ein Signal des Sende- und Empfangsteils des Anschlussplatzes zu einem auf der Abdeckung angeordneten Stromzähler durchzulassen oder weiterzuleiten. Dazu bleibt die Stelle 42 frei oder es wird ein lichtleitendes Material eingesetzt, z.B. Plexiglas, Glasfasern oder optische Fasern aus Kunststoff. Ist ein Stromzähler auf der Abdeckung angeordnet, ist eine Kommunikation mit dem Anschlussplatz möglich und es kann festgestellt werden, ob der Stromzähler sich auf der Abdeckung befindet.

## Patentansprüche

1. Abdeckung für den Anschlussplatz eines Stromzählers, insbesondere elektronischen Haushaltszählers, und ggf. Halterung für den später anzuschließenden Stromzähler, die in ihrer Funktionsstellung gesichert ist durch ein Riegelelement (15), das von der Abdeckung in den Anschlussplatz greift und gegen Entfernen aus der Eingriffstellung, insbesondere durch eine Plombierung (26), gesichert werden kann,
**dadurch gekennzeichnet,**
**dass** das Riegelelement (15) federnd an der Abdeckung angeordnet ist derart, dass es beim Positionieren der Abdeckung in ihrer Funktionsstellung in eine Eingriffstellung an dem Anschlussplatz einrastet.

2. Abdeckung nach Anspruch 1,
**dadurch gekennzeichnet,**
**dass** das Riegelelement (15) an einem federnden Arm (12) der Abdeckung angeordnet ist.

3. Abdeckung nach Anspruch 2,
**dadurch gekennzeichnet,**
**dass** eine Eingriffsmöglichkeit (22) für ein Werkzeug, insbesondere für einen Schraubendreher, derart eingerichtet ist, dass der federnde Arm (12) mittels des Werkzeuges angehoben werden kann.

4. Abdeckung nach einem der Ansprüche 1 bis 3, mit einer Grundplatte (2), deren Rückseite im Wesentlichen wie die Rückseite des Stromzählers gestaltet ist mit Haken (7) zum Befestigen an einer Befestigungs- und Kontaktiereinrichtung des Anschlussplatzes und Stiften (8) zum Eingreifen in die Kontaktiereinrichtung, wobei die Haken (7) und Stifte (8) in einer Montagestellung in die Befestigungs- und Kontaktiereinrichtung zu stecken sind bis zur Anlage der Grundplatte (2) an dem Anschlussplatz und dann die Abdeckung nach unten in die Funktionsstellung zu verschieben ist,
**gekennzeichnet durch** eine Anordnung des Riegelelements (15) an dem Arm (12) derart, dass es sich bei dem Anlegen der Grundplatte (2) an dem Anschlussplatz in der Montagestellung unter Verbiegen des Armes (12) zurückdrücken lässt und beim Verschieben der Abdeckung in die Funktionsstellung in seine Eingriffstellung an dem Anschlussplatz einrastet.

5. Abdeckung nach Anspruch 4,
**dadurch gekennzeichnet,**
**dass** an dem Riegelelement eine schräge Rutschfläche (16) ausgebildet ist, mittels derer es sich bei Rückverschieben der Abdeckung in die Montagestellung aus der Eingriffstellung heraushebt.

6. Abdeckung nach einem der Ansprüche 2 bis 5,
**dadurch gekennzeichnet,**
**dass** der, vorzugsweise durch einen Einschnitt (11) in einer bzw. der genannten Grundplatte (2) gebildete, federnde Arm (12) gegen Anheben gesichert werden kann durch einen Plombendraht (26), für den eine Führung (25) quer über den Arm oder einen Ansatz (14) des Armes (12) unter Gegenhaltern (24) der Abdeckung vorgesehen ist, vorzugsweise mit nur geringfügigen Spalten (11) zwischen dem Arm oder Ansatz und den Gegenhaltern.

7. Abdeckung nach Anspruch 6,
**dadurch gekennzeichnet,**
**dass** der Arm oder Ansatz (14) an der Stelle des Plombendrahtes (26) zweischenklig ist und drei, vorzugsweise als Konsolen (24) auf der Grundplatte (2) ausgebildete, Gegenhalter vorgesehen sind.

8. Abdeckung nach Anspruch 6 oder 7,
**dadurch gekennzeichnet,**
**dass** die Gegenhalter (24) den Plombendraht (26) von oben bogenförmig einfassen und die Bögen (25) an ihrer offenen Seite in der axialen Projektion durch den Arm oder den Ansatz (14) des Armes geschlossen sind.

9. Abdeckung nach einem der Ansprüche 2 bis 8,
**dadurch gekennzeichnet,**
**dass** der federnde Arm (12) ebenfalls gegen Anheben gesichert werden kann durch ein Steckschloss, für das auf dem federnden Arm (12) eine Aufnahme (18) und an der Abdeckung eine dem Schwenkriegel des Steckschlosses zugewandte Gegenfläche (21) ausgebildet ist oder umgekehrt.

10. Abdeckung nach einem der Ansprüche 2 bis 9,
die zugleich Halterung für den später anzuschließenden Stromzähler ist,
**dadurch gekennzeichnet,**
**dass** der federnde Arm (12) ebenfalls gegen Anheben gesichert werden kann durch den aufgesetzten Stromzähler, wobei die Abdeckung und Halterung die Form eines flachen Kastens (1) aufweist, in dem bei auf die Seitenwände (3 - 6) des Kastens (1) aufgesetztem Stromzähler die an der Rückseite des Stromzählers herausragenden Stifte Platz finden, und der Zwischenraum zwischen dem Arm (12) und dem Stromzähler durch einen Aufbau (17) auf dem Arm (12) überbrückt ist, vorzugsweise durch die genannte Aufnahme (18) für das Steckschloss, und der aufgesetzte Stromzähler seinerseits gegen Abnehmen gesichert werden kann.

11. Abdeckung und Halterung nach Anspruch 10,
**dadurch gekennzeichnet,**
**dass** der aufgesetzte Stromzähler gegen Abnehmen gesichert werden kann durch ein Steckschloss, für das die Abdeckung und Halterung eine Aufnahme (27) aufweist, die an der einen Schmalseitenwand (5) des Kastens (1) ausschwenkbar angebracht ist, wobei das Steckschloss den Stromzähler gegen Rückverschieben aus der der genannten Funktionsstellung entsprechenden Haltestellung sichert, in der seine Haken, die in an den Außenseiten der Längsseitenwände (3;4) des Kastens (1) ausgebildeten Taschen (9) Platz finden, hinter in den Taschen (1) geformte Widerlager (10) greifen.

12. Abdeckung für den Anschlussplatz eines Stromzählers, insbesondere elektronischen Haushaltszählers, und ggf. Halterung für den später anzuschließenden Stromzähler, mit einer Grundplatte (2), deren Rückseite im Wesentlichen wie die Rückseite eines Stromzählers gestaltet ist mit Haken (7) zum Befestigen an einer Befestigungs- und Kontaktiereinrichtung des Anschlussplatzes, wobei die Haken (7) in einer Montagestellung in die Befestigung- und Kontaktiereinrichtung zu stecken sind bis zur Anlage der Grundplatte (2) an dem Anschlussplatz und dann die Abdeckung nach unten in die Funktionsstellung zu verschieben ist,
**dadurch gekennzeichnet,**
**dass** die Haken (7) in der Richtung, in der die Abdeckung in ihre Funktionsstellung zu verschieben ist, nicht über einen Rand (43) von jeweils gegenüberliegend zu den Haken (7) auf der anderen Seite der Abdeckung angeordneten, zur Aufnahme von Haken des Stromzählers vorgesehenen Tasche (9) ragen.

13. Abdeckung nach Anspruch 12,
**dadurch gekennzeichnet,**
**dass** der Rand (43) ein Widerlager (10) für jeweils einen der Haken des Stromzählers bildet.

14. Abdeckung für den Anschlussplatz eines Stromzählers, insbesondere elektronischen Haushaltszählers, und ggf. Halterung für den später anzuschließenden Stromzähler,
**dadurch gekennzeichnet,**
**dass** die Abdeckung zur Wechselwirkung mit einer an dem Anschlussplatz angeordneten Sende- und Empfangseinrichtung vorgesehen ist.

15. Abdeckung nach Anspruch 14,
**dadurch gekennzeichnet,**
**dass** die Sende- und Empfangseinrichtung zum Senden und Empfangen von optischen Signalen vorgesehen ist und an der Abdeckung eine ein Sendesignal der Sende- und Empfangseinrichtung zu ihrem Sender zurücklenkende Einrichtung, vorzugsweise ein Spiegel oder eine Prismenanordnung, vorgesehen ist.
